# EUROPÄISCHE PATENTSCHRIFT

(11) **EP 2 107 576 B1**
(45) Veröffentlichungstag und Bekanntmachung des Hinweises auf die Patenterteilung: **16.03.2016**
(21) Anmeldenummer: 08162811.7
(22) Anmeldetag: 22.08.2008
(51) Int. Cl.: H01F 27/02, H01F 27/29, H05K 3/46, H05K 1/18

(54) **Induktionsbauteil**
Induction component
Composant à induction

(30) Priorität: 31.03.2008 DE 102008017303
(43) Veröffentlichungstag der Anmeldung: 07.10.2009
(73) Patentinhaber: Würth Elektronik Rot am See GmbH & Co. KG, 74585 Rot am See (DE)
(72) Erfinder: Murawski, Jörg, 74676 Niedernhall (DE); Kostelnik, Jan, 74592 Kirchberg (DE); Wolf, Jürgen, 74635 Kupferzell (DE)
(74) Vertreter: Patentanwälte Ruff, Wilhelm, Beier, Dauster & Partner mbB

(56) Entgegenhaltungen:
- EP-A1- 1 398 803
- EP-A1- 1 734 543
- DE-A1- 3 131 057
- DE-U1- 8 604 096
- US-B1- 6 662 431
- US-B1- 7 236 075
- US-B2- 6 912 781

## Beschreibung

Die Erfindung betrifft ein Induktionsbauteil, das in einem Gehäuse mindestens eine Spule aufweist, deren Spulenwindung(en) mit an dem Gehäuse ausgebildeten Anschlusselementen verbunden ist sind. Mit den an der Außenseite des Gehäuses vorhandenen Anschlusselementen wird das Induktionsbauteil mit Anschlusspads einer Leiterplatte verbunden.

Es ist bereits ein Induktionsbauteil dieser Art bekannt (US 6662431 B1). Das Gehäuse ist kastenförmig ausgebildet und weist eine offene der Leiterplatte zugewandte Unterseite auf. Die Stirnenden des Gehäuses sind höher, so dass sie bei der Montage eines solchen Bauteils auf der Leiterplatte aufliegen können. Die Anschlusselemente des Gehäuses sind in den Seitenwänden eingeformt, wobei ein Schenkel aus den Kanten der Seitenwände herausragt. Dieser herausragende Schenkel hat die Aufgabe, dass die Enden der Spulenwindungen um ihn herum gewickelt werden können. Auf diese Weise erfolgt eine Verbindung der Spulenwindungen mit dem Anschlusselementen des Gehäuses. Die Spule wird beim Ausgießen des Innenraums des Gehäuses eingebettet.

Aus der europäischen Offenlegungsschrift EP 1 734 543 A1 ist ein Induktionsbauteil mit einem Gehäuse, wobei das Gehäuse eine offene Unterseite aufweist, und mehreren in das Gehäuse eingesetzten Spulen bekannt. Die mehreren Spulen werden mit Anschlusselementen am Gehäuse verbunden und dann beim Ausgießen des Innenraums des Gehäuses eingebettet.

Aus dem deutschen Gebrauchsmuster DE 86 04 096 U1 ist ein weiteres Induktionsbauteil bekannt, bei dem eine Spule mit Anschlusselementen des Gehäuses verbunden und vollständig innerhalb des Gehäuses in Kunststoff eingebettet wird.

Aus der US-Patentschrift US 7,236,075 B1 ist ein Induktionsbauteil mit einem Gehäuse, das eine offene Unterseite aufweist, und einem für das Gehäuse vorgesehenen Deckel bekannt. Der Deckel weist mehrere Anschlusselemente auf. Mehrere Spulen werden mit den Anschlusselementen des Deckels verbunden und dann beim Ausgießen des Gehäuses eingebettet.

Aus der deutschen Offenlegungsschrift DE 31 31 057 A1 ist ein Induktionsbauteil bekannt, bei dem eine Spule auf einen Spulenkern aufgewickelt und dann innerhalb eines kastenförmigen Gehäuses angeordnet wird.

Aus der US-Patentschrift US 6,912,781 B2 ist ein Induktionsbauteil bekannt, bei dem Spulen mit elektrischen Anschlusselementen eines trogartigen Gehäuses verbunden und dann beim Ausgießen des Innenraums des Gehäuses eingebettet werden.

Aus der europäischen Offenlegungsschrift EP 1 398 803 A1 ist das Herstellen einer Spule aus einem flächigen Zuschnitt, der mehrfach gefaltet wird, so dass im gefalteten Zustand der Spule mehrere Windungen aufeinanderliegen, bekannt.

Der Erfindung liegt die Aufgabe zu Grunde, ein Induktionsbauteil mit einem Gehäuse und mindestens einer in dem Gehäuse angeordneten Spule so auszugestalten, dass es sich mit geringerem Aufwand und mit weniger Fehlermöglichkeiten herstellen lässt.

Zur Lösung dieser Aufgabe schlägt die Erfindung ein Induktionsbauteil mit den im Anspruch 1 genannten Merkmalen vor. Die Erfindung schlägt ebenfalls ein Verfahren zur Herstellung eines solchen Bauteils mit den Merkmalen von Anspruch 5 vor.

Das von der Erfindung vorgeschlagene Induktionsbauteil enthält also ein Gehäuse, das auch einen Deckel beziehungsweise je nach Betrachtungsweise einen Boden aufweist. Auf diesem Boden ist mindestens eine Spule angebracht, die in zusammengesetzten Zustand des Gehäuses innerhalb des Gehäuses angeordnet ist. Die Anbringung der Spule auf einem Deckel des Gehäuses hat den Vorteil, dass sich dies wesentlich einfacher durchführen lässt, da der Deckel eben ist.

In Weiterbildung der Erfindung kann vorgesehen sein, dass das Gehäuse kastenförmig ausgebildet ist und die Anschlusselemente, mit denen das Induktionsbauteil zu seiner eigentlichen Verwendung mit einer Leiterplatte verbunden wird, aus den Seitenwänden des Gehäuses herausgeführt sind. Es kann sich dabei um federnd geformte Anschlusselemente handeln.

Bei der Spule kann es sich um eine herkömmliche als Drahtwicklung hergestellte Drahtspule handeln. Diese Spule kann insbesondere um einen Kern herum gewickelt seien. Der Kern kann die Form eines Torus oder auch eines Mehrecks aufweisen.

In Weiterbildung der Erfindung kann vorgesehen sein, dass mindestens eine Spule als so genannte Faltflex Spule ausgebildet ist.

Ebenfalls möglich ist es, dass mindestens eine Spule als Planarspule ausgebildet ist.

Es liegt im Rahmen der Erfindung, das auf dem Boden beziehungsweise Deckel des Gehäuses mehrere Spulen auch unterschiedlich ausgebildet sind, je nach den Anforderungen des Einzelfalles.

Besonders sinnvoll ist es aber, wenn alle Spulen in identischer Technologie ausgebildet sind.

Erfindungsgemäß kann vorgesehen sein, dass mindestens eine Faltflex Spule einen gedruckten Magnet aufweist.

Die Kontaktierung zwischen dem Boden beziehungsweise Deckel und dem Gehäuse kann erfindungsgemäß durch Löten hergestellt sein. Ebenfalls möglich ist die Herstellung der Kontaktierung durch Einpressen oder auch durch Crimpen.

Das Verfahren zur Herstellung des Induktionsbauteils nach der Erfindung läuft wie in Anspruch 5 definiert ab.

Insbesondere kann mindestens eine Spule als Drahtspule gewickelt werden, beispielsweise um einen Kern.

Es ist aber ebenfalls möglich, mindestens eine Spule als Faltflex Spule herzustellen.

Auf die Faltflex Spule kann ein Magnet aufgedruckt werden.

Ebenfalls möglich ist es, mindestens eine Spule als Planarspule herzustellen.

Weitere optionale Merkmale, Einzelheiten und Vorzüge der Erfindung ergeben sich aus den abhängigen Ansprüchen der folgenden Beschreibung bevorzugter Ausführungsformen der Erfindung sowie anhand der Zeichnungen. Hierbei zeigen:
- Figur 1: schematisch einen Schnitt durch ein noch nicht fertiggestelltes Induktionsbauteil nach der Erfindung;
- Figur 2: eine der Figur 1 entsprechende Darstellung bei einer anderen Art des Aufbaus;
- Figur 3: einen Schnitt durch das fertig gestellte Induktionsbauteil;
- Figur 4: eine Ausführungsform eines Induktionsbauteils, die nicht Teil der Erfindung ist;
- Figur 5: einen der Figur 1 entsprechenden Schnitt bei einer nochmals weiteren Ausführungsform;
- Figur 6: die perspektivische Ansicht einer Faltflex Spule mit aufgedrucktem Magnetkern;
- Figur 7: einen Schnitt durch ein Stück einer Leiterplatte, die später den Boden eines Gehäuses bilden soll;
- Figur 8: den Schnitt der Figur 7 nach Herstellung eines Hohlraums;
- Figur 9: den Schnitt der Figur 8 mit eingesetzter Faltflex Spule;
- Figur 10: den Schnitt durch die Leiterplatte nach ihrer Kontaktierung;
- Figur 11: eine den Figuren 1 bis 5 entsprechende Darstellung einer weiteren Ausführungsform eines Induktionsbauteils, die nicht Teil der Erfindung ist; einem
- Figur 12: die Anordnung eines eine Spule enthaltenden Bauteils in Gehäuse;
- Figur 13: die perspektivische Ansicht eines Teils eines Gehäuses bei einer weiteren Ausführungsform eines Induktionsbauteils, die nicht Teil der Erfindung ist;
- Figur 14: eine der Figur 13 entsprechende Darstellung einer weiteren Ausführungsform eines Induktionsbauteils, die nicht Teil der Erfindung ist;
- Figur 15: eine vereinfachte Darstellung entsprechend Figur 13 und Figur 14.

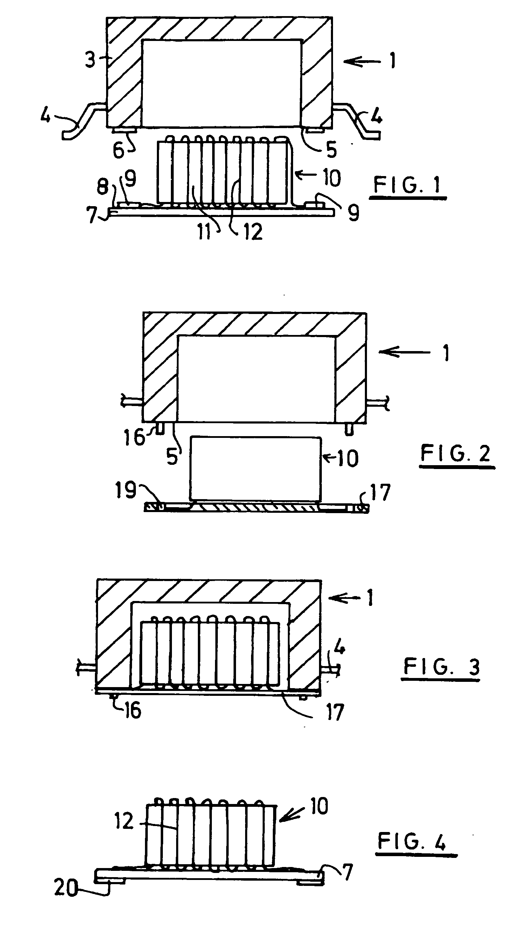

Das in Figur 1 in auseinander gezogenem Zustand dargestellte Induktionsbauteil enthält ein Gehäuse 1 in Form eines Kastens. Dieses Gehäuse ist im Querschnitt dargestellt. Das Gehäuse 1 enthält eine offene Unterseite 2. In den Seitenwänden 3 sind eine Vielzahl von Anschlussbeinen 4 eingeformt, deren aus der Außenseite der Außenwände 3 herausragende Teile nach unten abgewinkelt sind und zur Verbindung mit Anschlusspads einer Leiterplatte dienen. Innerhalb der Seitenwände 3 sind diese Anschlusselemente eingeformt und ragen mit ihrem jeweiligen inneren Ende aus den Kanten 5 der Seitenwände 3 geringfügig heraus und bilden dort eine Lötfläche 6. Es gibt eine Vielzahl solcher Anschlussbeine 4, die alle hintereinander angeordnet sind, so dass in Figur 1 nur jeweils das dargestellte Anschlussbein 4 zu sehen ist.

Zu dem Induktionsbauteil gehört ein Deckel 7, der auch als Boden bezeichnet werden kann, wenn man von dem Gehäuse 1 sagt, dass es eine offene Unterseite aufweist. Im folgenden wird aber der Begriff Deckel verwendet. Die Größe des Deckels 7 ist so bemessen, dass er angenähert von der Außenseite der linken Seitenwand 3 bis zur Außenseite der rechten Seitenwand 3 reicht. Auf der dem Gehäuse 1 zugewandtem Innenseite 8 enthält der Deckel 7 den Lötflächen 6 gegenüberliegend ebenfalls Lötflächen 9 in Form von metallischen Anschlusspads. Jedem inneren Ende 6 eines Anschlussbeins 4 ist also eine Lötfläche 9 auf der Innenseite des Deckels 7 zugeordnet.

Auf der Innenseite 8 des Deckels 7 ist eine Spule 10 befestigt, die einen Spulenkern 11 und mindestens eine um den Spulenkern 11 herum gewickelte Drahtwicklung 12 aufweist. Die Spule 10 ist beispielsweise auf die Innenseite des Deckels 7 aufgeklebt. Die Enden der Drahtwicklung 12 sind mit den Lötflächen 9 verbunden.

In diesem Zustand ist es beispielsweise möglich, die elektrischen Eigenschaften der Spule 10 mithilfe der Lötflächen 9 zu überprüfen. Nach dieser Überprüfung wird das Induktionsbauteil in der Weise zusammengesetzt, dass der Deckel 7 mit der Spule 10 in das Innere des Gehäuses 1 gerichtet dem Gehäuse angenähert wird, und dass die jeweiligen Lötflächen 6, 9 miteinander verbunden werden, beispielsweise durch Löten. Natürlich ist es auch möglich, den frei bleibenden Raum im Inneren des Gehäuses mit einem Füllmaterial auszufüllen. Nach der Herstellung der mechanischen und elektrischen Verbindung zwischen dem Deckel 7 und dem Gehäuse 1 ist ein Bauteil entstanden, das als Bauteil gehandhabt werden kann. Der Zugriff auf die Spulen 10 im Inneren des Gehäuses 1 geschieht über die Anschlussbeine 4.

Bei der Ausführungsform nach Figur 1 geschieht die Verbindung zwischen den Lötflächen 9 und 6 mithilfe eines Lötvorgangs zwischen parallelen Flächen.

Figur 2 zeigt eine Ausführungsform, die der Ausführungsform nach Figur 1 sehr ähnlich ist. Einzelheiten der Spule 10 sind daher nicht mehr dargestellt. Jedoch enthält hier der Deckel 17 anstelle der Lötflächen 9 durchkontaktierte Bohrungen 19, denen gegenüberliegend an den Kanten 5 der Seitenwände 3 Kontaktstifte 16 ausgebildet sind. Diese Kontaktstifte 16 sind das einstückige Ende der Anschlussbeine 4. Beim Zusammensetzen werden die Kontaktstifte 16 in die durchkontaktierten Bohrungen 19 eingepresst und stellen auf diese Weise eine elektrische und auch eine mechanische Verbindung mit den durchkontaktierten Bohrungen 19 her. Mit diesen Bohrungen 19 sind die Enden der Spulenwindungen der Spule 10 verbunden. Dies ist angedeutet.

Das Ergebnis des Zusammensetzens ist in Figur 3 dargestellt. Die Kontaktstifte 16 können hier noch etwas aus der Außenseite des Deckels 17 herausragen.

Bei den bislang behandelten Ausführungsformen wird ein Gehäuse verwendet, das in seinen Abmessungen an bisher verwendete Gehäuse angepasst ist. Die Enden der Anschlussbeine 4 können also auf übliche Leiterplatten aufgelötet werden, wo die Anschlusspads in diesem Raster vorhanden sind. Fig. 4 zeigt eine Ausgestaltung eines Induktionsbauteils die nicht Teil der Erfindung ist. Dabei zeigt die Figur 4 nur den Deckel 7 mit der darauf befestigten Spule 10. Diesmal sind an der Unterseite beziehungsweise Außenseite des Deckels 7 Lötflächen 20 ausgebildet, mit denen die Enden der Spulenwindungen 12 durch den Deckel 7 hindurch verbunden sind. Dieser Deckel kann auf die Kanten 5 eines Gehäuses 1 aufgesetzt und dort befestigt werden, wobei diesmal eine mechanische Befestigung ausreicht. Damit ist dann ebenfalls ein Induktionsbauteil hergestellt, das mit Anschlusspads einer Leiterplatte durch Löten mechanisch und elektrisch verbunden werden kann.

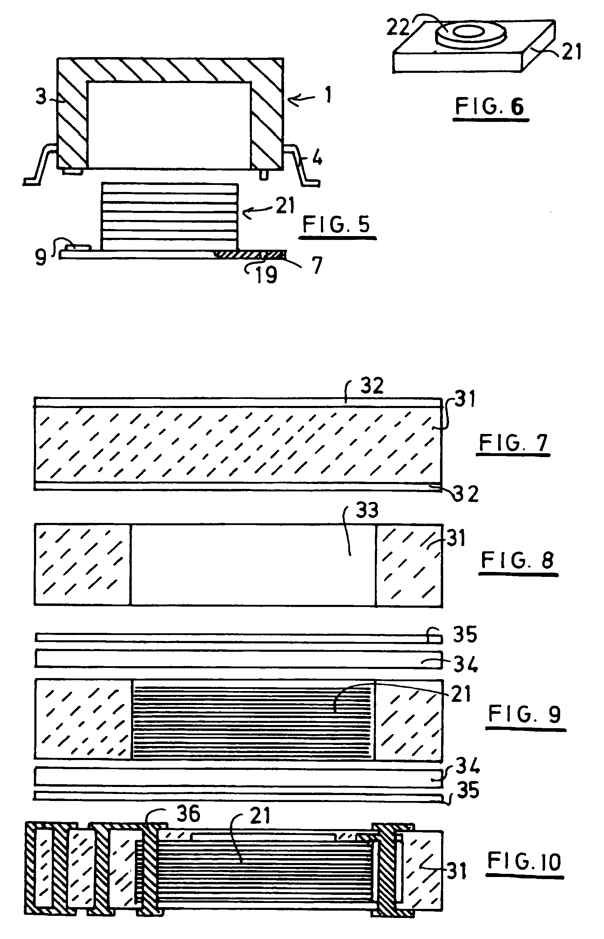

Während bisher eine um einen Kern 11 gewickelte Drahtspule dargestellt und beschrieben wurde, zeigt Figur 5 eine Möglichkeit, bei der auf die Innenseite 8 eines Deckels 7 eine Faltflex Spule 21 aufgebracht ist, beispielsweise ebenfalls durch Kleben. Die Herstellung von Faltflex Spulen ist eine bekannte Technologie.

In Figur 6 ist ein Beispiel dargestellt, wie auf eine Faltflex Spule 21 ein Magnet 22 aufgedruckt werden kann. Es ist andererseits auch möglich, Faltflex Spulen 21 in der Weise herzustellen, dass sie einen äußeren Magnetkern aufweisen.

Die Figuren 7 bis 10 zeigen eine Ausgestaltung die nicht Teil der Erfindung ist.

Bei dem Deckel 7 beziehungsweise 17 handelt es sich hierbei um ein Stück Leiterplatte selbst, in das eine Spule, insbesondere eine Faltflex Spule 21, eingebaut ist. Ausgangspunkt ist eine übliche Leiterplatte mit einer Kernschicht 31 und zwei metallischen Deckschichten 32. Zunächst werden die Deckschichten 32 entfernt, so dass nur die Kernschicht 31 übrig bleibt. In diese Kernschicht 31 wird eine Ausnehmung 33 eingebracht, die durchgehend ist. In die Vertiefung 33 wird dann eine vorher hergestellte Faltflex Spule 21 eingesetzt, und das ganze von beiden Seiten her mit einer Prepregschicht 34 und einer metallischen Deckschicht 35 laminiert. Anschließend werden zur Kontaktierung der Wicklungsenden der Faltflex Spule 21 Vias oder durchgehende Kontaktierungsmittels 36 eingebracht und entsprechend kontaktiert. Damit entsteht ein Gebilde, wie es in Figur 10 dargestellt ist. Dieses Gebilde kann nun als Deckel 7 verwendet werden, wobei dann das Gehäuse in seiner Höhe kleiner gestaltet werden kann, da über die Innenseite des Deckels dann keine Spule mehr vorsteht. Die Kontaktierung kann sowohl nach innen wie bei den Ausführungsformen nach Figur 1 bis 3 als auch nach außen wie bei der Ausführungsform nach Figur 4 erfolgen.

Das in Figur 10 dargestellte Gebilde, das in sich abgeschlossen ist, kann bei entsprechender Kontaktierung, beispielsweise an der Unterseite, an der Kante oder an der Oberseite, auch als eigenständiges Induktionsbauteil verwendet werden, sofern die Lötpads der Leiterplatte, mit der es verbunden werden soll, mit den entsprechenden Anschlussstellen dieses Bauelements übereinstimmen. In diesem Fall bildet das Stück Leiterplatte 31 mit der darin enthaltenen Öffnung 33 selbst das Gehäuse.

In den bisher dargestellten Beispielen erfolgte die Kontaktierung zwischen den Elementen auf dem Deckel 7, 17 und den dem Kasten des Gehäuses 1 zugeordneten Anschlussbeinen an den Kanten 5 der Seitenwände 3. Es ist selbstverständlich auch möglich, eine solche Kontaktierung an der Innenseite der Seitenwände 3 vorzunehmen, wobei auch Kombinationen verschiedener Kontaktierungen möglich sind. So zeigt beispielsweise die Figur 5, dass an der linken Seite eine Kontaktierung wie bei der Ausführungsform nach Figur 1 vorgesehen ist, während an der rechten Seite eine Kontaktierung wie in Figur 2 und 3 vorgesehen ist.

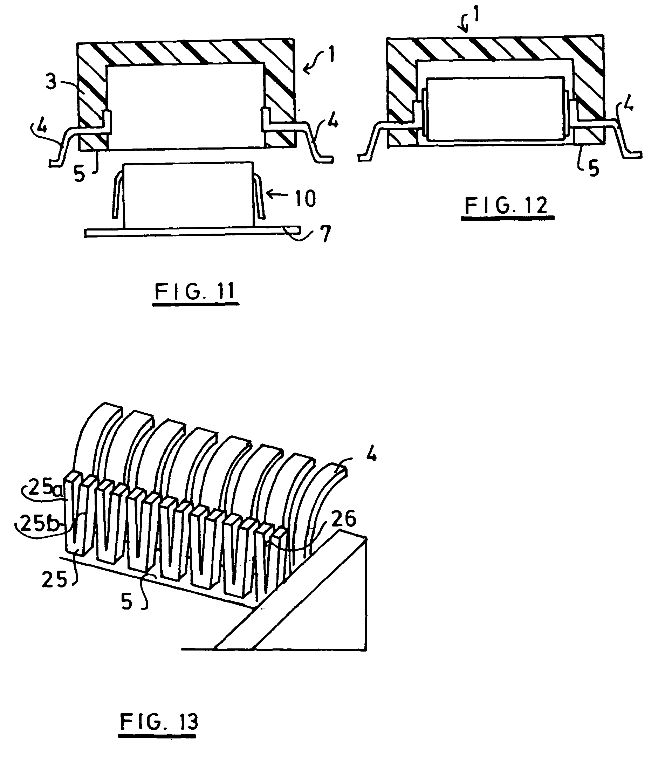

Figur 11 zeigt nun eine Möglichkeit die nicht Teil der Erfindung ist, wo die Kontaktierung zwischen den Enden der Spulenwicklungen und den Anschlussbeinen 4 des Gehäuses 1 nicht an den Kanten der Seitenwände 3 des Gehäuses 1, sondern an der Innenseite der Seitenwände 3 erfolgt. Die den Verbindungen mit den Spulen 10 zugeordneten Enden der Anschlussbeine 4 sind als Lötflächen innerhalb des Gehäuses angeordnet. Die Enden der Spulenwicklungen der Spulen 10 sind als flächige Kontaktbeine 44 ausgebildet und an den der Innenseite der Seitenwände zugeordneten Seiten der Spule 10 angeordnet. Der Deckel 7 mit den Spulen 10 wird in der gleichen Weise wie bei den vorhergehenden Ausführungsformen so dem Gehäuse angenähert, dass die Spulen 10 in das Innere des Gehäuses eingeschoben werden, worauf dann die Kontaktierung erfolgt.

Bei einer Anordnung einer als Faltflex Spule 21 ausgebildeten Spule in einem Stück Leiterplatte, wie dies die Figur 10 zeigt und die nicht Teil der Erfindung ist, ist es auch möglich, ein solches Bauelement in das Innere eines Gehäuses 1 einzusetzen und dort mit den Anschlussbeinen 4 zu verbinden, ohne dass ein Boden vorhanden ist. Hier kann die Leiterplatte mit den eingebauten Spulen selbst als Bauteil in ein Gehäuse eingebaut werden, wenn man aus Gründen der vorhandenen Infrastruktur solche Gehäuse verwenden will. Dies ist so in Figur 12 dargestellt.

Die Figur 13, nicht Teil der Erfindung zeigt perspektivisch einen Teil eines Gehäuses zur Unterbringung elektronischer Bauteile in einem Bereich von der offenen Seite her. Die Anschlussbeine 4 sind außerhalb des Gehäuses in ähnlicher Weise geformt wie bei den vorhergehenden Ausführungsformen. Ihre der Verbindung mit den in dem Gehäuse unterzubringenden Spulen oder dergleichen zugeordneten inneren Enden 25 ragen, ähnlich wie bei den Ausführungsformen nach den Figuren 1 bis 5 aus den Kanten 5 der Seitenwände 3 heraus. Diese Enden 25 sind also einstückig mit den Anschlussbeinen 4, und sie sind dadurch befestigt, dass sie in den Seitenwänden 3 des Gehäuses eingebettet sind. Die aus der Kante 5 der Seitenwände 3 herausragenden Enden 25 sind gegabelt, so dass zwischen den beiden Zinken 25a und 25b jeweils ein Schlitz 26 gebildet ist, der von zwei unter einem spitzen Winkel verlaufenden Seitenwänden begrenzt ist. Die Enden der Drähte der zu verbindenden Spulen können in diese Schlitze 26 eingelegt werden, so dass sie zunächst mechanisch gesichert sind, und dann angelötet oder angeschweißt werden.

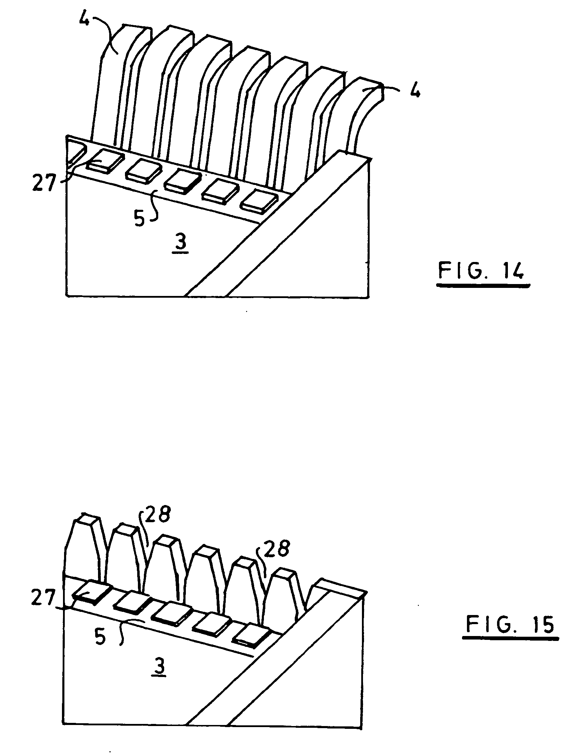

Figur 14, nicht Teil der Erfindung, zeigt eine der Figur 13 ähnliche Ausführungsform, bei der also die Kanten 5 der Seitenwände 3 nicht bündig mit dem stirnseitigen Endwänden des Gehäuses verlaufen. Auf den Kanten 5 sind Kontaktflächen 27 ausgebildet, die innerhalb der Seitenwände 3 einstückig mit den Anschlussbeinen 4 in Verbindung stehen. Der Aufbau ist also in gewisser Weise ähnlich wie bei der Ausführungsform nach Figur 1. Die Enden der Spulenwindungen können bei dieser Ausführungsform mit den Kontaktflächen 27 verlötet oder angeschweißt werden.

Es ist ebenfalls möglich, jedoch nicht Teil der Erfindung, dass die Spulen auf einer Leiterplatte als Träger bestückt werden und die Enden der Spulenwindungen in Drahtbondtechnologie mit dem Kontaktflächen 27 verbunden werden. Die Spulen können durch eine Vergussmasse geschützt werden.

Die Figur 15, nicht Teil der Erfindung, zeigt eine weitere Art, wie ein Gehäuse ausgebildet sein kann. Aus Gründen der Vereinfachung sind hier die äußeren Anschlussbeine vier weggelassen, Sie sind in der gleichen Weise zu denken, wie bei den vorhergehenden Ausführungsformen. Die Seitenwand drei ist mit einer Stufe ausgebildet, wobei die Stufe der bisherigen Kante fünf der Seitenwand entspricht. Auf dieser Kante fünf sind Kontaktflächen 27 ausgebildet, die bei der Ausführungsform der Figur 14. Außerhalb dieser Kante fünf weist das Gehäuse Schlitze 28 auf, ähnlich wie die Schlitze 26 bei der Ausführungsform der Figur 13. Hier dienen die Schlitze 18, die in der Kunststoffseitenwand vorhanden sind, nur zum Festhalten der Draht enden, die auf diese Weise mechanisch fixiert sind, so dass sich dann die Verbindung mit den Kontaktflächen 27 durch Schweißen, Löten einfacher durchführen lässt.

Der Innenraum des Gehäuses kann vollständig oder teilweise mit Vergussmasse gefüllt werden, um die Spulen zu sichern.

## Patentansprüche

1. Induktionsbauteil, insbesondere zur SMD-Montage, mit
einem Gehäuse (1), wobei das Gehäuse (1) eine offene Unterseite und einen Deckel (7, 17) beziehungsweise Boden zum Aufsetzen auf die offene Unterseite aufweist,
an dem Gehäuse (1) ausgebildeten Anschlusselementen (4) zur mechanischen und elektrischen Verbindung des Induktionsbauteils mit Anschlusspads einer Leiterplatte,
mindestens einer in dem Gehäuse (1) angeordneten Spule (10, 21), die
mindestens eine Spulenwicklung (12) aufweist,
deren Wicklungsenden mit den Anschlusselementen (4) des Induktionsbauteils elektrisch verbunden sind, **dadurch gekennzeichnet, dass**
die Spule (10, 21) auf dem Deckel (7, 17) beziehungsweise Boden des Gehäuses (1) angebracht ist und die Wicklungsenden mit Anschlussstellen (9, 19) auf dem Deckel (7, 17) beziehungsweise Boden verbunden sind, wobei die Spule (10, 21) im aufgesetzten Zustand des Deckels bzw. des Bodens auf die offene Unterseite innerhalb des Gehäuses (1) angeordnet ist und wobei elektrische Verbindungen zwischen den Anschlusselementen (4) des Gehäuses (1) und den Anschlussstellen (9, 19) des Deckels (7, 17) beziehungsweise Bodens durch das Verbinden des offenen Gehäuses (1) mit dem Deckel (7, 17) beziehungsweise Boden hergestellt sind.

2. Induktionsbauteil nach Anspruch 1, bei dem das Gehäuse (1) kastenförmig ausgebildet ist und die Anschlusselemente (4) aus den Seitenwänden (3) des Gehäuses (1) herausgeführt sind.

3. Induktionsbauteil nach einem der vorhergehenden Ansprüche, bei dem mindestens eine der mindestens einen Spule (10) als um einen Kern (11) gewickelte Drahtspule oder als Faltflex- Spule (21) oder als Planarspule ausgebildet ist

4. Induktionsbauteil nach einem der vorhergehenden Ansprüche, bei dem die elektrische Verbindung zwischen den Anschlussstellen (9, 19) des Bodens beziehungsweise Deckels (7, 17) und den Anschlusselementen (4) des Gehäuses (1) durch Löten und/oder durch Einpressen und/oder-durch Crimpen hergestellt ist.

5. Verfahren zum Herstellen eines zur SMD-Montage bestimmten Induktionsbauteils, mit folgenden Verfahrensschritten:
es wird ein Gehäuse (1) aus Kunststoff mit einer offenen Unterseite und an dem Gehäuse (1) ausgebildeten Anschlusselementen (4) hergestellt,
es wird mindestens eine Spule (10, 21) hergestellt,
die Spule (10,21) wird auf einen Boden beziehungsweise Deckel (7, 17) des Gehäuses (1) aufgebracht
die Wicklungsenden der Spulenwicklung werden auf dem Boden beziehungsweise Deckel (7,17) des Gehäuses mit definierten Anschlussstellen (9, 19) verbunden
der Deckel (7, 17) beziehungsweise Boden des Gehäuses wird mit der Spule (10) in das Innere des Gehäuses (1) gerichtet mit dem Gehäuse (1) verbunden
bei der Verbindung des Gehäuses (1) mit dem Deckel (7, 17) werden elektrische Verbindungen zwischen den Anschlusselementen (4) des Gehäuses (1) und den Anschlussstellen (9, 19) des Bodens hergestellt.

6. Verfahren nach Anspruch 5, bei dem mindestens eine der mindestens einen Spule als Drahtspule gegebenenfalls um einen Kern gewickelt oder als Faltflex Spule (21) oder als Planarspule hergestellt wird, wobei insbesondere auf mindestens eine Faltflex Spule (21) ein Magnet (22) aufgedruckt und/oder mindestens eine Spule auf den Boden beziehungsweise Deckel (7) aufgeklebt und/oder aufgedruckt wird.

## Claims

1. Induction component, in particular for SMD installation, comprising
a housing (1), wherein the housing (1) has an open underside and a cover (7, 17) or bottom, respectively, to be placed onto the open underside,
connecting elements (4) provided on the housing (1) for mechanical and electrical connection of the induction component to connecting pads of a circuit board,
at least one coil (10, 21) disposed within the housing (1), the coil including
at least one coil winding (12),
the winding ends thereof being electrically connected to the connecting elements (4) of the induction component,
**characterized in that**
the coil (10, 21) is attached to the cover (7, 17) or bottom, respectively, of the housing (1) and the winding ends are connected to connecting terminals (9, 19) on the cover (7, 17) or bottom, respectively, wherein the coil (10, 21) in the condition with the cover (7, 17) or bottom, respectively, placed onto the open underside, is disposed within the housing (1), and wherein electrical connections between the connecting elements (4) of the housing (1) and the connecting terminals (9, 19) of the cover (7, 17) or bottom, respectively, are produced by connecting the open housing (1) to the cover (7, 17) or bottom, respectively.

2. Induction component according to claim 1, wherein the housing (1) is box-shaped and the connecting elements (4) are led through the side walls (3) of the housing (1).

3. Induction component according to any one of the preceding claims, wherein at least one of the at least one coil (10) is a wire coil wound around a core (11) or a Faltflex coil (21) or a planar coil.

4. Induction component according to any one of the preceding claims, wherein the electrical connection between the connecting terminals (9, 19) of the bottom or cover (7, 17), respectively, and the connecting elements (4) of the housing (1) are produced by soldering and/or by pressing in and/or by crimping.

5. Method for the production of an induction component intended for SMD installation, comprising the following method steps:
producing a housing (1) made of synthetic material having an open underside and connecting elements (4) formed on the housing (1),
producing at least one coil (10, 21),
placing the coil (10, 21) on a bottom or cover (7, 17), respectively, of the housing (1),
connecting the winding ends of the coil winding to defined connecting terminals (9, 19) on the bottom or cover (7, 17), respectively, of the housing,
connecting the cover (7, 17) or bottom, respectively, of the housing to the housing (1), with the coil (10) oriented towards the interior of the housing (1),
producing electrical connections between the connecting elements (4) of the housing (1) and the connecting terminals (9, 19) of the bottom by connecting the housing (1) to the cover (7, 17).

6. Method according to claim 5, wherein at least one of the at least one coil is produced as a wire coil, as required wound around a core, or as a Faltflex coil (21) or a planar coil, wherein in particular a magnet (22) is printed onto at least one Faltflex coil (21) and/or at least one coil is adhesively bonded and/or printed onto the bottom or cover (7), respectively.

## Revendications

1. Composant à induction, notamment pour le montage CMS, avec
un boîtier (1), le boîtier (1) comportant une face inférieure ouverte et un couvercle (7, 17), respectivement un fond à placer sur la face inférieure ouverte,
des éléments de raccordement (4) conçus sur le boîtier (1) pour la liaison mécanique et électrique du composant à induction avec des plots de connexion d'une carte de circuits imprimés,
au moins une bobine (10, 21) placée dans le boîtier (1), qui
comporte au moins un enroulement de bobine (12),
dont les extrémités d'enroulement sont électriquement connectées avec les éléments de raccordement (4) du composant à induction, **caractérisé en ce que**
la bobine (10, 21) est montée sur le couvercle (7, 17), respectivement le fond du boîtier (1) et **en ce que** les extrémités d'enroulement sont reliées avec des points de raccordement (9, 19) sur le couvercle (7, 17), respectivement le fond, à l'état dans lequel le couvercle, respectivement le fond est posé sur la face inférieure ouverte, la bobine (10, 21) étant placée à l'intérieur du boîtier (1) et des connexions électriques étant créées entre les éléments de raccordement (4) du boîtier (1) et les points de raccordement (9, 19) du couvercle (7, 17), respectivement du fond, par la liaison du boîtier (1) ouvert avec le couvercle (7, 17), respectivement le fond.

2. Composant à induction selon la revendication 1, sur lequel le boîtier (1) est conçu en forme de caisson et les éléments de raccordement (4) sont tirés hors des parois latérales (3) du boîtier (1).

3. Composant à induction selon l'une quelconque des revendications précédentes, sur lequel au moins l'une de l'au moins une bobine (10) est conçue en tant que bobine de fil métallique enroulée autour d'une âme (11) ou en tant que bobine Faltflex (21) ou en tant que bobine planaire.

4. Composant à induction selon l'une quelconque des revendications précédentes, sur lequel la connexion électrique entre les points de raccordement (9, 19) du fond, respectivement du couvercle (7, 17) et les éléments de raccordement (4) du boîtier (1) est créée par brasage et/ou par forçage et/ou par sertissage.

5. Procédé destiné à fabriquer un composant destiné au montage CMS, avec les étapes de procédé suivantes :
on fabrique un boîtier (1) en matière plastique avec une face inférieure ouverte et des éléments de raccordement (4) conçus sur le boîtier (1),
on fabrique au moins une bobine (10, 21),
on applique la bobine (10, 21) sur un fond, respectivement un couvercle (7, 17) du boîtier (1),
on relie les extrémités d'enroulement de l'enroulement de bobine sur le fond, respectivement le couvercle (7, 17) du boîtier avec des points de raccordement (9, 19) définis,
on relie le couvercle (7, 17), respectivement le fond du boîtier avec le boîtier (1), la bobine (10) étant dirigée à l'intérieur du boîtier,
lors de la liaison du boîtier (1) avec le couvercle (7, 17), on crée des connexions électriques entre les éléments de raccordement (4) du boîtier (1) et les points de raccordement (9, 19) du fond.

6. Procédé selon la revendication 5, lors duquel on enroule au moins l'une de l'au moins une bobine en tant que bobine en fil métallique autour d'une âme ou on la fabrique en tant que bobine Faltflex (21) ou en tant que bobine planaire, alors qu'on presse un aimant (22) sur au moins une bobine Faltflex (21) et/ou on colle et/ou on presse au moins une bobine sur le fond, respectivement le couvercle (7).
